# EUROPEAN PATENT APPLICATION

(11) **EP 4 693 394 A1**
(43) Date of publication of application: **11.02.2026**
(21) Application number: 24796137.8
(22) Date of filing: 24.04.2024
(51) Int. Cl.: H01L 23/31, H01L 23/473, H01L 23/367, H05K 1/02, H05K 7/20

(54) **CHIP PACKAGE STRUCTURE AND ELECTRONIC DEVICE**

(30) Priority: 25.04.2023 CN 202310475079
(71) Applicant: Huawei Technologies Co., Ltd., Shenzhen, Guangdong 518129 (CN)
(72) Inventor: XIONG, Jianbo, Shenzhen, Guangdong 518129 (CN); LIANG, Xiaotong, Shenzhen, Guangdong 518129 (CN); LU, Jun, Shenzhen, Guangdong 518129 (CN)
(74) Representative: Goddar, Heinz J.
(86) International application number: PCT/CN2024/089678
(87) International publication number: WO 2024/222761

(57) **Abstract**

Embodiments of this application disclose a chip package structure and an electronic device. The chip package structure includes a substrate and a housing, where the housing includes a first support and a top plate, the first support is disposed around the substrate, and the top plate is disposed on the first support; a chip and a supporting member, disposed on a first surface of the substrate, where the supporting member is disposed around the chip, and both the chip and the supporting member are located in a cavity; a spraying module, where the spraying module is disposed on the housing, and the spraying module faces the chip; and a first sealing member, where the first sealing member is disposed between the supporting member and the housing. In this way, heat may be dissipated for the chip in a liquid cooling manner, thereby improving heat dissipation performance of the chip. The sealing member is disposed between the supporting member and the housing along a radial direction, to seal a region outside the first surface of the substrate, and prevent coolant from entering the region, thereby improving stability of an electrical connector of the substrate. In addition, this facilitates disassembly/assembly, and reduces pressure on the chip during mounting.

## Description

This application claims priority to Chinese Patent Application No. 202310475079.2, filed with the China National Intellectual Property Administration on April 25, 2023 and entitled "CHIP PACKAGE STRUCTURE AND ELECTRONIC DEVICE", which is incorporated herein by reference in its entirety.

### TECHNICAL FIELD

Embodiments of this application relate to the field of electronic technologies, and in particular, to a chip package structure and an electronic device.

### BACKGROUND

Currently, as power consumption of an electronic device increases, a chip generates a large amount of heat during running. If the heat is not effectively dissipated to ensure that the chip runs at a safe temperature, a service life of the chip is sharply shortened, and even the chip may be burnt. Therefore, a heat dissipation technology is a key technology that supports further development of electronic technologies.

Some chips are connected to a heat dissipation structure by using a thermal interface material (Thermal Interface Material, TIM) for heat dissipation. As power consumption and power consumption densities of the chips continuously increase, thermal resistance of the TIM accounts for 30% to 40% of system thermal resistance, which cannot meet a heat dissipation requirement of the chips.

When a liquid cooling technology is used to dissipate heat for the chip, water may be directly sprayed to a surface of the chip, achieving better heat dissipation effect. Therefore, the liquid cooling technology may be used for heat dissipation of the chip.

### SUMMARY

Embodiments of this application provide a chip package structure and an electronic device, to resolve a problem of poor heat dissipation effect of a thermal interface material.

To achieve the foregoing objectives, the following technical solutions are used in embodiments of this application.

According to a first aspect of embodiments of this application, a chip package structure is provided. The chip package structure includes a substrate and a housing, where the housing includes a first support and a top plate, the first support is disposed around the substrate, and the top plate is disposed on the first support; a chip and a supporting member, disposed on a first surface of the substrate, where the supporting member is disposed around the chip, and both the chip and the supporting member are located in a cavity; a spraying module, where the spraying module is disposed on the housing, and the spraying module faces the chip; and a first sealing member, where the first sealing member is disposed between the supporting member and the housing. In this way, heat may be dissipated for the chip through coolant in a liquid cooling manner, thereby improving heat dissipation performance of the chip. In addition, the supporting member is disposed on the substrate, and the sealing member is disposed between the supporting member and the housing along a radial direction, to seal a region outside the substrate, and prevent the coolant from entering the region, thereby improving stability of an electrical connector on a lower surface of the substrate. Further, the sealing member is used for radial sealing, so that sealing reliability can be implemented without a need of a connection member for fastening. This facilitates disassembly/assembly, and pressure acting on the chip during mounting can be converted into friction force of the sealing member, thereby avoiding squeezing on the chip.

In an optional implementation, the first sealing member is located between an outer side wall of the supporting member and an inner side wall of the first support. In this way, the first support may evenly disperse gravity of the top plate, and the first support and the supporting member may be used for mounting of the first sealing member.

In an optional implementation, a first groove is provided on a surface that is of the supporting member and that faces the first support. The first sealing member is partially disposed in the groove, and a surface of the first sealing member is in contact with the inner side wall of the first support. In this way, the groove is provided on the surface of the supporting member, so that the sealing member can be better fastened, and the sealing member does not slide up and down, thereby improving sealing effect.

In an optional implementation, a first groove is provided on a surface that is of the first support and that faces the supporting member. The first sealing member is partially disposed in the groove, and a surface of the first sealing member is in contact with the outer side wall of the supporting member. In this way, the groove is provided on the surface of the first support, so that the sealing member can be better fastened, and the sealing member does not slide up and down, thereby improving sealing effect.

In an optional implementation, the housing further includes a second support. The second support is located on an inner side of the first support, and is disposed around the spraying module. The first sealing member is disposed between an outer side wall of the second support and the inner side wall of the supporting member. In this way, a position of the sealing member is flexibly provided, and the second support and the supporting member may be used for mounting of the first sealing member.

In an optional implementation, the spraying module includes a coolant inflow channel, a coolant outflow channel, and a nozzle. The coolant outflow channel is in communication with the cavity, the coolant inflow channel is in communication with the cavity through the nozzle, and the nozzle faces the chip. In this way, coolant may be evenly sprayed onto a surface of the chip for cooling.

In an optional implementation, the chip package structure further includes an input external connector. The input external connector is disposed in the coolant inflow channel. A second sealing member is disposed between the input external connector and the coolant inflow channel. In this way, a gap between the input external connector and the coolant inflow channel can be sealed, to prevent coolant from flowing out of the gap.

In an optional implementation, a second groove is provided on a surface that is of the coolant inflow channel and that faces the input external connector. The second sealing member is partially disposed in the second groove, and a surface of the second sealing member is in contact with an outer side wall of the input external connector. In this way, the second groove is provided, so that the second sealing member can be better fastened, and the second sealing member does not slide up and down, thereby improving sealing performance of the chip package structure.

In an optional implementation, the chip package structure further includes an output external connector. The output external connector is disposed in the coolant outflow channel, and a third sealing member is disposed between the output external connector and the coolant outflow channel. In this way, a gap between the output external connector and the coolant outflow channel can be sealed, to prevent coolant from flowing out of the gap.

In an optional implementation, a third groove is provided on a surface that is of the coolant outflow channel and that faces the output external connector. The third sealing member is partially disposed in the third groove, and a surface of the third sealing member is in contact with an outer side wall of the output external connector. In this way, the third groove is provided, so that the third sealing member can be better fastened, and the third sealing member does not slide up and down, thereby further improving sealing performance of the chip package structure.

In an optional implementation, the chip package structure further includes a printed circuit board. Both the substrate and the housing are disposed on the printed circuit board, the housing and the printed circuit board enclose a cavity, and the substrate is located in the cavity. In this way, the housing is connected to the printed circuit board, so that clamping force during mounting of the housing is not transferred to the electrical connector between the substrate and the printed circuit board, thereby reducing pressure on the electrical connector.

In an optional implementation, the housing further includes a connection portion. The connection portion is disposed on the printed circuit board, the connection portion is connected to the support, and the connection portion is connected to the printed circuit board by using a connection member. In this way, the connection portion may be fastened on the printed circuit board, improving stability of packaging. This prevents the spraying module from striking the chip under kinetic energy during falling or impact, thereby avoiding a surface defect on the chip or crushing of the electrical connector.

In an optional implementation, a fourth sealing member is disposed between the connection portion and the printed circuit board. In this way, a gap between the connection portion and the printed circuit board can be better sealed, to further prevent coolant from flowing out of the gap.

In an optional implementation, a fourth groove is provided on a surface that is of the connection portion and that faces the printed circuit board. The fourth sealing member is partially disposed in the fourth groove, and a surface of the fourth sealing member is in contact with the first surface of the printed circuit board. In this way, the fourth groove is provided, so that the fourth sealing member can be better mounted, and the sealing member does not slide, thereby improving sealing effect.

In an optional implementation, the chip package structure further includes a reinforcing plate. The reinforcing plate is disposed on a second surface of the printed circuit board, and the reinforcing plate is connected to the printed circuit board by using a connection member. In this way, bending resistance performance of the printed circuit board can be improved by disposing the reinforcing plate.

According to a second aspect of embodiments of this application, a chip module is provided. The chip module includes: a substrate; a chip and a housing, both disposed on a first surface of the substrate, where the housing and the substrate enclose a cavity, and the chip is located in the cavity; a spraying module, where the spraying module is disposed on the housing, the spraying module faces the chip, and a coolant transmission channel is provided on the spraying module; an external connector, where the external connector is disposed in the coolant transmission channel; and a sealing member, where the sealing member is disposed between an outer side wall of the external connector and an inner side wall of the coolant transmission channel. In this way, heat may be dissipated for the chip through coolant in a liquid cooling manner, thereby improving heat dissipation performance of the chip. In addition, the sealing member is disposed between the outer side wall of the external connector and the inner side wall of the coolant transmission channel along a radial direction, so that coolant leakage can be avoided, and sealing performance of the chip package structure is improved. Further, the sealing member is used for radial sealing, so that sealing reliability can be implemented without a connection member for fastening.

In an optional implementation, the external connector includes an input external connector, the coolant transmission channel includes a coolant inflow channel, and the sealing member includes a first sealing member. The input external connector is disposed in the coolant inflow channel, and the first sealing member is disposed between the input external connector and the coolant inflow channel. In this way, a gap between the input external connector and the coolant inflow channel can be sealed, to prevent coolant from flowing out of the gap.

In an optional implementation, a first groove is provided on a surface that is of the coolant inflow channel and that faces the input external connector. The first sealing member is partially disposed in the first groove, and a surface of the first sealing member is in contact with an outer side wall of the input external connector. In this way, the first groove is provided, so that the first sealing member can be better fastened, and the first sealing member does not slide up and down, thereby improving sealing performance of the chip package structure.

In an optional implementation, the external connector includes an output external connector, the coolant transmission channel includes a coolant outflow channel, and the sealing member includes a second sealing member. The output external connector is disposed in the coolant outflow channel, and the second sealing member is disposed between the output external connector and the coolant outflow channel. In this way, a gap between the output external connector and the coolant outflow channel can be sealed, to prevent coolant from flowing out of the gap.

In an optional implementation, a second groove is provided on a surface that is of the coolant outflow channel and that faces the output external connector. The second sealing member is partially disposed in the second groove, and a surface of the second sealing member is in contact with an outer side wall of the output external connector. In this way, the second groove is provided, so that the second sealing member can be better fastened, and the second sealing member does not slide up and down, thereby further improving sealing performance of the chip package structure.

In an optional implementation, the chip package structure further includes: a printed circuit board and a supporting member. The substrate and the supporting member are disposed on a first surface of the printed circuit board, and the supporting member is disposed around the substrate. In this way, the supporting member may further protect the substrate.

In an optional implementation, the supporting member includes a support and a first connection portion. The first connection portion is located at one end of the support, the first connection portion is disposed close to the printed circuit board, and the first connection portion is connected to the printed circuit board by using a first connection member. In this way, the supporting member is connected to the printed circuit board by using the first connection member. This improves connection stability, and clamping force cannot be transferred to the substrate, thereby avoiding squeezing on an electrical connector between the substrate and the printed circuit board. This prevents the spraying module from striking the chip under kinetic energy during falling or impact, thereby avoiding a surface defect on the chip or crushing of the electrical connector.

In an optional implementation, a third sealing member is disposed between the first connection portion and the printed circuit board. In this way, a gap between the first connection portion and the printed circuit board can be better sealed, to further prevent coolant from flowing out of the gap.

In an optional implementation, a third groove is provided on a surface that is of the first connection portion and that faces the printed circuit board. The third sealing member is partially disposed in the third groove, and a surface of the third sealing member is in contact with the first surface of the printed circuit board. In this way, the third groove is provided, so that the third sealing member can be better mounted, and the sealing member does not slide, thereby improving sealing effect.

In an optional implementation, the chip package structure further includes an external connector support. The external connector support is disposed on the top of the supporting member. The supporting member further includes a second connection portion. The second connection portion is located at another end of the supporting member, and the external connector support is connected to the second connection portion by using the second connection member. In this way, connection stability of the chip package structure can be further improved.

According to a third aspect of embodiments of this application, an electronic device is provided. The electronic device includes the foregoing chip package structure. In this way, the electronic device dissipates heat for a chip in a liquid cooling manner by using the foregoing chip package structure, thereby improving heat dissipation performance and implementing better sealing performance.

In an optional implementation, the electronic device is a router or a server. In this way, the chip module has a wider range of applications.

### BRIEF DESCRIPTION OF DRAWINGS

FIG. 1 is a partial diagram of an electronic device according to an embodiment of this application;
FIG. 2 is a diagram of a heat dissipation structure of a chip;
FIG. 3 is a diagram of a structure of a chip package structure according to an embodiment of this application;
FIG. 4 is a diagram of a pressure change process during chip packaging according to an embodiment of this application;
FIG. 5 is a diagram of a structure of another chip package structure according to an embodiment of this application;
FIG. 6 is a diagram of a structure of another chip package structure according to an embodiment of this application;
FIG. 7 is a diagram of a structure of another chip package structure according to an embodiment of this application;
FIG. 8 is a diagram of a structure of another chip package structure according to an embodiment of this application;
FIG. 9 is a diagram of a structure of another chip package structure according to an embodiment of this application;
FIG. 10 is a diagram of a structure of another chip package structure according to an embodiment of this application;
FIG. 11 is a diagram of a structure of another chip package structure according to an embodiment of this application;
FIG. 12 is a diagram of a structure of another chip package structure according to an embodiment of this application; and
FIG. 13 is a diagram of a structure of another chip package structure according to an embodiment of this application.

### DESCRIPTION OF EMBODIMENTS

To make the objectives, technical solutions, and advantages of this application clearer, the following further describes this application in detail with reference to the accompanying drawings.

The terms "first" and "second" mentioned below are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more.

In addition, in this application, position terms such as "upper", and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

This application provides an electronic device. The electronic device may be a router, a server, or the like.

The electronic device includes: a printed circuit board (Printed Circuit Board, PCB), a substrate disposed on the printed circuit board, and a chip disposed on the substrate. The chip may be an integrated circuit chip.

The printed circuit board may be a silicon printed circuit board, a laminated printed circuit board, a ceramic printed circuit board, an interposer, or any other suitable support structure. The printed circuit board PCB 17 may use a flame-resistant material (FR-4) dielectric board, a Rogers (Rogers) dielectric board, a hybrid dielectric board of Rogers and FR-4, or the like. Herein, FR-4 is a grade designation of a flame-resistant material, and the Rogers dielectric board is a high-frequency board. An electronic element, for example, a chip, is carried on the PCB 17.

The substrate is configured to carry a chip, and the chip may be connected to the circuit board through the substrate.

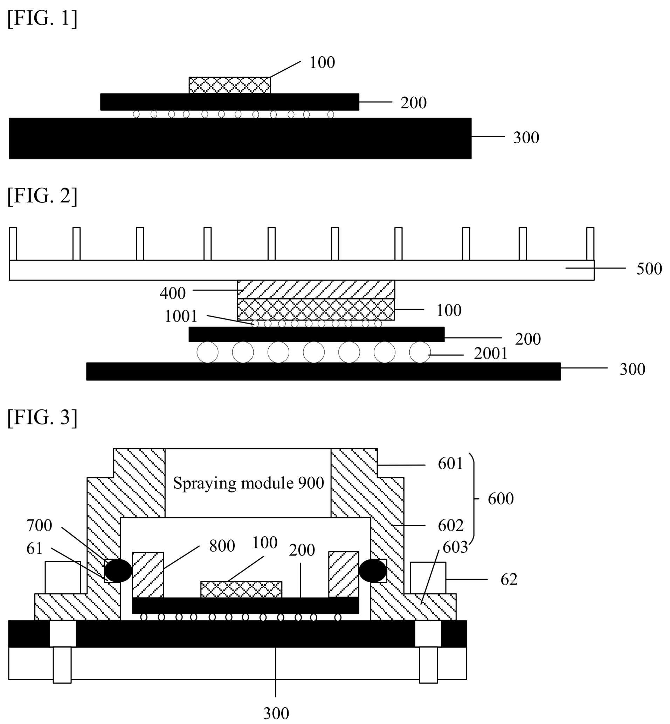

As shown in FIG. 1, the chip 100 is electrically connected to the substrate 200, and the substrate 200 is connected to a printed circuit board 300, so that the chip 100 can perform signal transmission with an electronic system in the electronic device. In this application, the chip may be specifically a die (die).

To improve heat dissipation performance of the chip, a heat dissipation structure may be disposed on the chip.

As shown in FIG. 2, the chip 100 is disposed on the substrate 200, and is electrically connected to the printed circuit board 300 through the substrate 200. A heat sink 500 is disposed on a side that is of the chip 100 and that is away from the substrate 200.

In some embodiments of this application, the chip 100 is electrically connected to the substrate 200 by using a first electrical connector 1001. In some embodiments of this application, the substrate 200 is electrically connected to the printed circuit board 300 by using a second electrical connector 2001.

Structures of the first electrical connector 1001 and the second electrical connector 2001 are not limited in this embodiment of this application. For example, the first electrical connector 1001 and the second electrical connector 2001 may include a plurality of evenly arranged solder balls.

A structure of the heat sink 500 is not limited in this embodiment of this application. In some embodiments of this application, the heat sink 500 includes a copper or aluminum heat sink, a vapor chamber (Vapor chamber, VC), an evaporator, and a liquid cooling heat sink (including a cooling plate). In some other embodiments of this application, the heat sink 500 further includes heat sink teeth, so that a heat dissipation surface of the heat sink 500 can be increased, thereby improving heat dissipation performance.

In some embodiments of this application, a thermal interface material 400 is disposed between the chip 100 and the heat sink.

In some embodiments of this application, the thermal interface material 400 may be a flexible thermally conductive material. The thermal interface material 400 includes thermal gel, thermal silicone grease, or a thermal pad.

However, as power densities of the chip 100 increases, a larger temperature difference caused by thermal resistance of the thermal interface material 400 results in poorer heat dissipation effect.

Therefore, an embodiment of this application provides an improved chip package structure. A spraying module is disposed on the chip package structure. The spraying module sprays liquid to a chip, and dissipates heat for the chip by using a liquid cooling technology.

As shown in FIG. 3, the chip package structure includes a substrate 200, a printed circuit board 300, a chip 100, a housing 600, and a spraying module 900.

The housing 600 is disposed on the printed circuit board 300, the housing 600 and the substrate 200 enclose a first cavity, and the chip 100 and the substrate 200 are located in the first cavity. The chip 100 is disposed on a surface of the substrate 200.

For example, each of the substrate 200 and the printed circuit board 300 includes a first surface and a second surface that are opposite to each other. A first surface of the substrate 200 is opposite to a second surface of the printed circuit board 300, and one or more chips 100 are disposed on a second surface of the substrate 200.

A structure and a material of the housing 600 are not limited in this embodiment of this application. In an implementation of this application, the housing 600 includes an upper cover.

The upper cover and the printed circuit board 300 are interlocked together, and the substrate 200 is located in a region enclosed by the upper cover and the printed circuit board 300.

In some embodiments of this application, the upper cover includes, for example, a top plate 601 and a first support 602. The first support 602 is supported on the printed circuit board 300, and the first support 602 is disposed around the chip 100.

Molding manners of the first support 602 and the top plate 601 are not limited in this embodiment of this application. In an implementation of this application, the first support 602 may be made of a same material as the top plate 601. During processing, the first support 602 and the top plate 601 may be integrally die-casted, and one end that is of the first support 602 and that is away from the top plate 601 may be fastened to the printed circuit board 300 through an adhesive.

In another implementation of this application, the first support 602 and the top plate 601 may be separately die-casted. For example, the first support 602 includes a first end and a second end that are opposite to each other. The first end of the first support 602 may be fastened to the top plate 601 through an adhesive, and the second end of the first support 602 may be fastened to the printed circuit board 300 through an adhesive.

A specific structure of the first support 602 is not limited in this embodiment of this application. In an implementation of this application, the first support 602 may be of a ring structure, and the first support 602 is, for example, evenly supported at an edge of the printed circuit board 300.

In this way, the first support 602 may support the top plate 601 on the printed circuit board 300, and evenly disperse gravity of the top plate 601 on the printed circuit board 300.

A connection manner between the upper cover and the printed circuit board 300 is not limited in this embodiment of this application. In some embodiments of this application, the upper cover is fastened to the printed circuit board 300 by using a bolt.

In some embodiments of this application, the housing 600 further includes a first connection portion 603. The first connection portion 603 is disposed on the substrate 200, and the first connection portion 603 is connected to the support.

The printed circuit board 300 includes a first surface and the second surface that are opposite to each other. The first surface of the printed circuit board 300 is connected to the first connection portion 603, and the second surface of the printed circuit board 300 faces away from the first connection portion 603.

In some embodiments of this application, the printed circuit board 300 is connected to the first connection portion 603 by using a first connection member 62. The first connection member 62 may be a bolt, a screw, or the like.

The spraying module 900 is disposed on the top plate 601, and the spraying module 900 is opposite to the chip 100. The spraying module 900 is configured to spray coolant onto the chip 100, to dissipate heat for the chip 100.

For example, the coolant is a water working medium, for example, pure water. Pure water is used as the coolant, which is low in cost and convenient to use. In some possible implementations, the foregoing coolant is a mixed solution of pure water and glycol, or a mixed solution of pure water and propylene glycol, or may be another heat-carrying fluid with a high specific heat capacity.

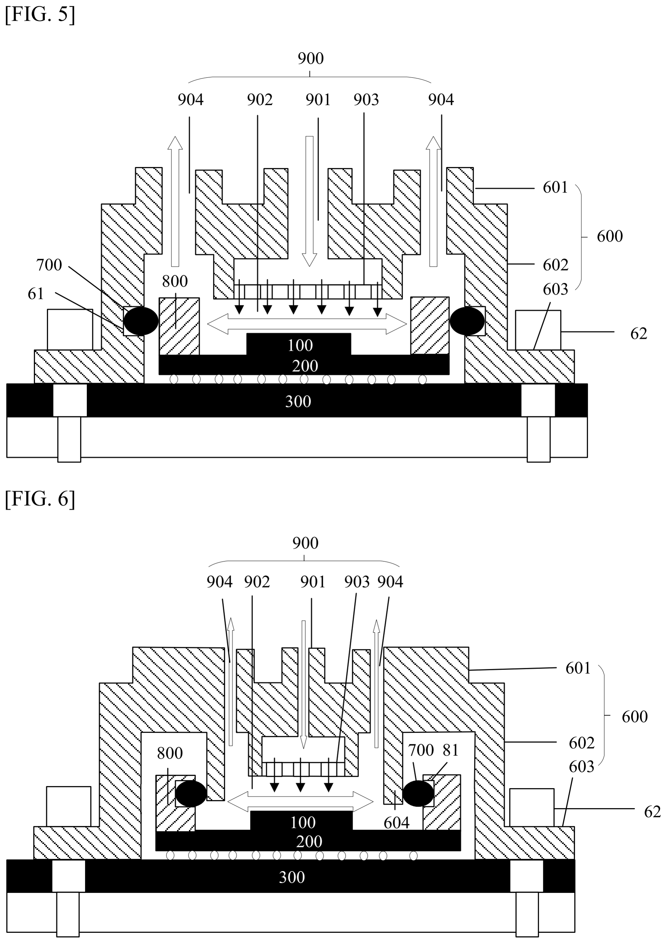

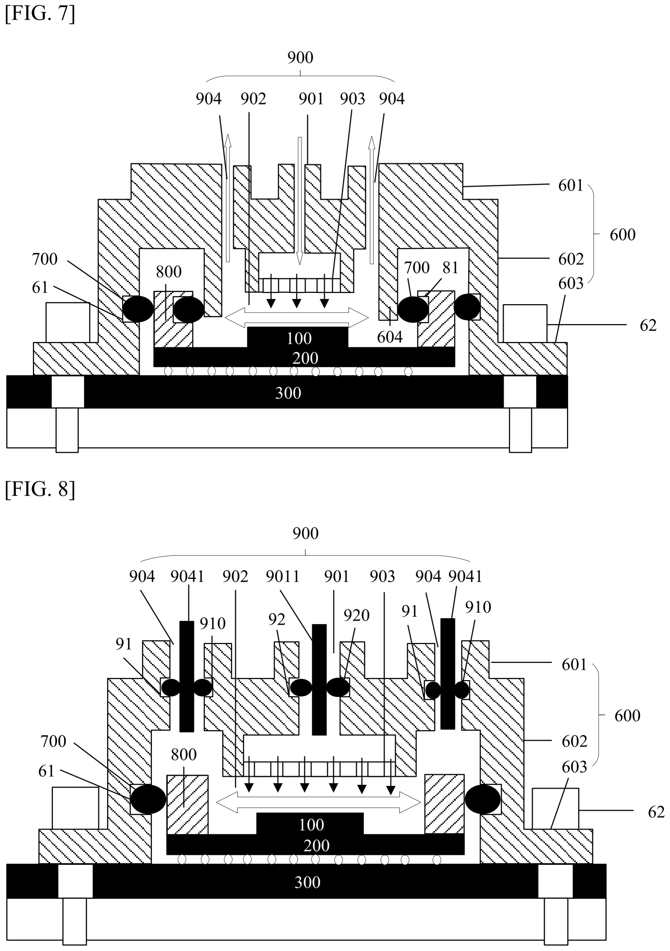

In some embodiments of this application, as shown in FIG. 5, the spraying module 900 includes a cavity 902, a coolant inflow channel 901, and a coolant outflow channel 904. One or more chips 100 are disposed in the cavity 902. FIG. 8 shows one chip 100 disposed in the cavity 902, that is, one cavity 902 corresponds to one chip 100. In another implementation, more than one chip 100 may be disposed in one cavity 902.

In this embodiment of this application, quantities and positions of the coolant inflow channel 901 and the coolant outflow channel 904 are not limited. In some embodiments, as shown in FIG. 5, there is one coolant inflow channel 901 and two coolant outflow channels 904. A quantity of coolant inflow channels 901 is, for example, the same as a quantity of chips 100, that is, one coolant inflow channel 901 corresponds to one chip 100.

Still refer to FIG. 5. A position of the coolant inflow channel 901 is, for example, opposite to a position of the chip 100. The chip 100 is disposed, for example, in a middle position of the substrate 200, the coolant inflow channel 901 is, for example, opposite to a center of the chip 100, and the two coolant outflow channels 904 are disposed on two sides of the coolant inflow channel 901, so that coolant may enter the spraying module 900 through the middle coolant inflow channel 901 to cool the chip 100, and flow out through the coolant outflow channel 904.

In addition, a nozzle 903 facing the chip 100 is disposed on a surface of the cavity. The coolant flows into the nozzle 903 through the coolant inflow channel 901, and then the nozzle 903 sprays the coolant onto a surface of the chip 100 located in the cavity 902. After heat dissipation is performed on the chip 100, the coolant flows into the coolant outflow channel 904, and then flows out of the spraying module 900 through the coolant outflow channel 904.

In this way, according to a cooling module provided in this embodiment of this application, the coolant is sprayed onto the surface of the chip 100 by using the nozzle 903 built in the spraying module 900, to implement centralized and targeted heat dissipation for the chip 100, thereby improving heat dissipation efficiency of the chip 100.

The substrate 200 is electrically connected to the printed circuit board 300 by using a second electrical connector 2001, and the coolant enters between the substrate 200 and the printed circuit board 300, which easily affects conductive performance of the second electrical connector 2001. Therefore, a region between the substrate 200 and the printed circuit board 300 needs to be sealed.

In an embodiment, as shown in FIG. 3, the chip package structure 100 further includes a first sealing member 700 and a supporting member 800.

The supporting member 800 is disposed, for example, on the second surface of the substrate 200. In some embodiments, the supporting member 800 is connected to the substrate 200 by using an adhesive.

The supporting member 800 is disposed, for example, around the chip 100. The first sealing member 700 is disposed between the supporting member 800 and the housing 600. The first sealing member 700 is disposed between the supporting member 800 and the housing 600 along a radial direction, and may be configured to seal a gap between the supporting member 800 and the housing 600, so as to prevent the coolant sprayed by the spraying module 900 from passing through the gap and entering the region between the substrate 200 and the printed circuit board 300.

Shapes of the supporting member 800 and the first sealing member 700 are not limited in this embodiment of this application. For example, the shapes of the supporting member 800 and the first sealing member 700 include regular shapes such as a circle, an ellipse, and a polygon, or irregular shapes.

The disposing along the radial direction means disposing along a straight line direction of a diameter or a radius of the chip package structure, or along a straight line direction perpendicular to an axis of the chip package structure. When disposed along the radial direction, the first sealing member 700 is fastened between the supporting member 800 and the housing 600 under pressure of the supporting member 800 and the housing 600 along the radial direction, to seal the gap between the supporting member 800 and the housing 600.

For example, the substrate 200, the printed circuit board 300, the supporting member 800, the housing 600, and the first sealing member 700 jointly enclose sealed space. Similarly, the spraying module 900, the substrate 200, the supporting member 800, the housing 600, and the first sealing member 700 jointly enclose a cooling cavity, and the chip 100 is located in the cavity.

During operation, the coolant sprayed by the spraying module 900 flows to the nozzle 903 through the coolant inflow channel 901, and then the nozzle 903 sprays the coolant onto the surface of the chip 100 located in the cavity 902. After heat dissipation is performed on the chip 100, the coolant flows into the coolant outflow channel 904, and then flows out of the spraying module 900 through the coolant outflow channel 904. The coolant cannot enter the region between the substrate 200 and the printed circuit board 300 due to arrangement of the first sealing member 700, to avoid an impact on conductive performance of the second electrical connector 2001.

The first sealing member 700 is of an O-ring (O-Ring) structure, a cross-sectional shape of the first sealing member 700 is, for example, a circle, and a material of the first sealing member 700 includes an elastic material such as rubber. The first sealing member 700 may deform under squeezing and impact of the coolant, to release stress.

A manner of disposing the first sealing member 700 between the supporting member 800 and the housing 600 is not limited in this embodiment of this application.

In some embodiments of this application, as shown in FIG. 5, the first sealing member 700 is disposed between an inner side wall of the first support 602 and an outer side wall of the supporting member 800.

In some other embodiments, as shown in FIG. 6, the housing 600 further includes a second support 604. The second support 604 is located in the cavity 902, is connected to the top plate 601, and is disposed around the spraying module 900. The first sealing member 700 is disposed between an outer side wall of the second support 604 and an inner side wall of the supporting member 800.

In some other embodiments, as shown in FIG. 7, first sealing members 700 are disposed between the outer side wall of the second support 604 and the inner side wall of the supporting member 800, and between the inner side wall of the first support 602 and the outer side wall of the supporting member 800.

In another embodiment, the second support 604 may alternatively be disposed on an outer side of the supporting member 800, and the first sealing member 700 is disposed between the second support 604 and the supporting member 800.

A mounting manner of the first sealing member 700 is not limited in this embodiment of this application.

In an embodiment of this application, as shown in FIG. 5, the first sealing member 700 may be sleeved on the outer side wall of the supporting member 800, so that the first sealing member 700 is in contact with the inner side wall of the first support 602.

Alternatively, as shown in FIG. 6, the first sealing member 700 may be sleeved on the outer side wall of the second support 604, so that the first sealing member 700 is in contact with the inner side wall of the supporting member 800.

In another embodiment of this application, as shown in FIG. 5, a first groove 61 is provided on an inner side of the first support 602. The first sealing member 700 is partially disposed in the first groove 61 of the first support 602, and a surface of the first sealing member 700 is in contact with the supporting member 800.

Alternatively, as shown in FIG. 6, a groove 81 is provided on an outer side wall of the supporting member 800. The first sealing member 700 is partially disposed in the groove 81 of the supporting member 800, and a surface of the first sealing member 700 is in contact with the second support 604.

In another embodiment, a groove is provided on the inner side wall of the supporting member 800. The first sealing member 700 is disposed in the groove 61 of the supporting member 800, and a surface of the first sealing member 700 is in contact with the first support 602.

Alternatively, a groove 81 is provided on the outer side wall of the second support 604. The first sealing member 700 is partially disposed in the groove 81 of the second support 604, and a surface of the first sealing member 700 is in contact with the supporting member 800.

In other embodiments, a first groove 61 is provided on each of the inner side wall of the first support 602 and the outer side wall of the supporting member 800. One part of the first sealing member 700 is disposed in the groove of the supporting member 800, and the other part of the first sealing member 700 is disposed in the groove of the first support 602.

Alternatively, a groove 81 is disposed on each of the inner side wall of the supporting member 800 and the outer side wall of the second support 604. One part of the first sealing member 700 is disposed in the groove of the supporting member 800, and the other part of the first sealing member 700 is disposed in the groove of the second support.

After the coolant sprayed by the spraying module 900 enters the cavity 902, the first sealing member 700 may deform under squeezing and impact of the coolant, to release stress. This prevents the squeezing and impact of the coolant on the cavity from being transferred to a connection structure between the housing 600 and the printed circuit board 300, reduces stress on an interface between the housing 600 and the printed circuit board 300, and improves connection strength of the interface between the housing 600 and the printed circuit board 300.

According to the chip package structure provided in this embodiment of this application, heat may be dissipated for the chip through the coolant in a liquid cooling manner, thereby improving heat dissipation performance of the chip. In addition, the supporting member is disposed on the substrate, the housing is disposed on the printed circuit board, and the sealing member is disposed between the supporting member and the housing along the radial direction, to seal the region between the substrate and the printed circuit board, and prevent the coolant from entering the region, thereby improving stability of the electrical connector between the substrate and the printed circuit board.

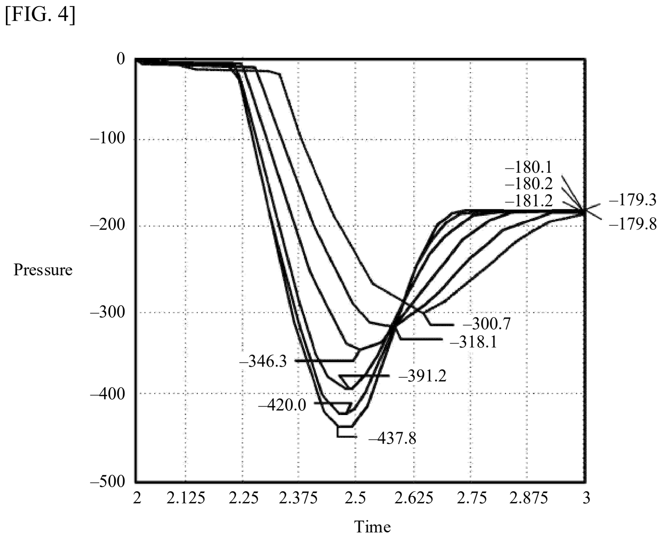

FIG. 4 is a diagram of a pressure change process during chip packaging according to an embodiment of this application. When the housing 600 is mounted on the printed circuit board 300, pressure of the housing 600 on the chip 100 may be converted into friction force of the sealing member, and the friction force is small, thereby reducing squeezing pressure on the chip 100 and avoiding collapse of the electrical connector between the chip 100 and the substrate 200.

Further, the sealing member is used for radial sealing, so that sealing reliability can be implemented without a connection member for fastening. This facilitates disassembly/assembly, and pressure acting on the chip during mounting can be converted into the friction force of the sealing member, thereby avoiding squeezing on the chip. In addition, the housing is connected to the printed circuit board, so that clamping force during mounting of the housing is not transferred to the electrical connector between the substrate and the printed circuit board, thereby reducing pressure on the electrical connector.

A quantity of the first sealing members 700 and positions of the first sealing members 700 are not limited in this embodiment of this application. In some embodiments, as shown in FIG. 8, a first groove 61 is provided on the inner side of the first support 602, the first sealing member 700 is partially disposed in the first groove 61 of the first support, and a surface of the first sealing member 700 is in contact with the supporting member 800.

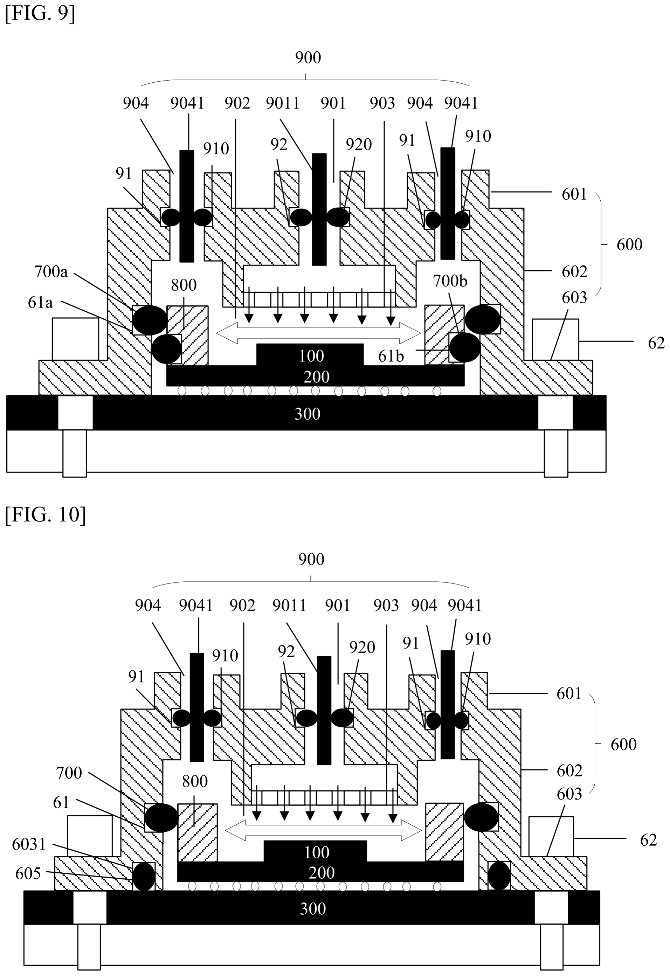

In some other embodiments, as shown in FIG. 9, there are two first sealing members 700: a sealing member 700a and a sealing member 700b, and there are also two first grooves 61: a groove 61a and a groove 61b.

The groove 61a is provided on the inner side wall of the first support 602, the sealing member 700a is partially disposed in the groove 61a, and a surface of the sealing member 700a is in contact with the supporting member 800.

The groove 61b is provided on the outer side wall of the supporting member 800, the sealing member 700b is partially disposed in the groove 61b of the supporting member 800, and the sealing member 700b is in contact with the inner side wall of the first support 602.

In another embodiment, a plurality of first grooves 61 may be all provided on the inner side wall of the first support 602, or a plurality of first grooves 61 may be all provided on the outer side wall of the supporting member 800. These all fall within the protection scope of this application.

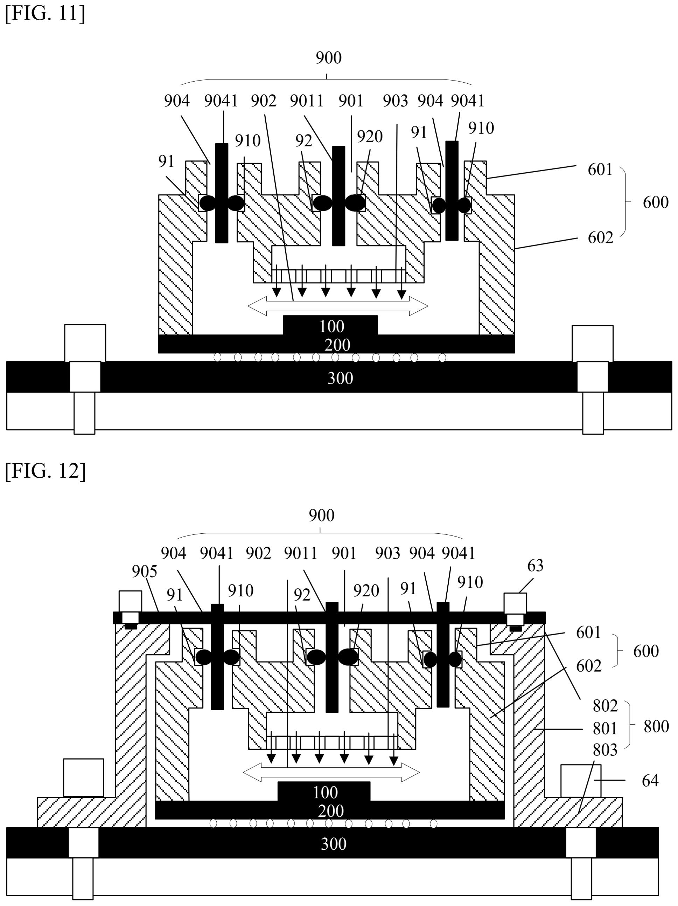

In addition, as shown in FIG. 8 and FIG. 11, the chip package structure further includes an external connector. The external connector may be classified into an input external connector 9011 and an output external connector 9041. The input external connector 9011 is located in the coolant inflow channel 901, and the output external connector 9041 is located in the coolant outflow channel 904. The input external connector 9011 is configured to input coolant into the spraying module 900, and the output external connector 9041 is configured to export coolant in the cavity 902.

Quantities and positions of input external connectors 9011 and output external connectors 9041 are not limited in this embodiment of this application. In some embodiments, as shown in FIG. 8, there is one input external connector 9011 and two output external connectors 9041. A quantity of input external connectors 9011 is, for example, the same as a quantity of chips 100. That is, one input external connector 9011 corresponds to one chip 100.

Still refer to FIG. 8. A position of the input external connector 9011 is, for example, opposite to a position of the chip 100. The chip 100 is disposed, for example, in a middle position of the substrate 200, the input external connector 9011 is, for example, opposite to a center of the chip 100, and the two output external connectors 9041 are disposed on two sides of the input external connector 9011, so that coolant may enter the spraying module 900 through the middle input external connector 9011 to cool the chip 100 and flow out through the output external connector 9041.

In addition, a nozzle 903 facing the chip 100 is disposed on a surface of the cavity. In some embodiments, a cross-sectional size of the nozzle 903 is greater than or equal to a cross-sectional size of the chip 100, so that the nozzle 903 can disperse the coolant input by the input external connector 9011, and evenly spray the coolant onto a surface of the chip 100, thereby improving heat dissipation performance of the spraying module.

The coolant flows to the nozzle 903 through the input external connector 9011, and then the nozzle 903 sprays the coolant onto the surface of the chip 100 located in the cavity 902. After heat dissipation is performed on the chip 100, the coolant flows into the output external connector 9041, and then flows out of the spraying module 900 through the output external connector 9041.

In this way, the input external connector 9011 is disposed opposite to the chip 100, so that the coolant input by the input external connector 9011 can be directly sprayed onto the surface of the chip 100, thereby better cooling the chip 100.

In some embodiments of this application, to further improve sealing performance of the cavity, a second sealing member 910 may be further disposed between the output external connector 9041 and the coolant outflow channel 904.

In some other embodiments of this application, a third sealing member 920 may be further disposed between the input external connector 9011 and the coolant inflow channel 901.

Both the second sealing member 910 and the third sealing member 920 are, for example, O-rings (O-Rings). Cross-sectional shapes of the second sealing member 910 and the third sealing member 920 are, for example, circles, and materials of the second sealing member 910 and the third sealing member 920 include an elastic material such as rubber. The second sealing member 910 and the third sealing member 920 may deform under squeezing and impact of the coolant, to release stress.

Mounting manners of the second sealing member 910 and the third sealing member 920 are not limited in this embodiment of this application. In some embodiments, the second sealing member 910 may be sleeved on an outer side wall of the output external connector 9041, so that the second sealing member 910 is in contact with an inner side wall of the coolant outflow channel 904.

In addition, the third sealing member 920 may be sleeved on an outer side wall of the input external connector 9011, to allow the third sealing member 920 be in contact with the coolant inflow channel 901.

In some other embodiments, refer to FIG. 8. A second groove 91 may be further provided on the inner side wall of the coolant outflow channel 904. The second sealing member 910 is partially disposed in the second groove 91, and a surface of the second sealing member 910 is in contact with the output external connector 9041.

In addition, a third groove 92 may be further provided on an inner side wall of the coolant inflow channel 901. The third sealing member 920 is partially disposed in the third groove 92, and a surface of the third sealing member 920 is in contact with the input external connector 9011.

During operation, the input external connector 9011 inputs coolant into the spraying module, so that the coolant flows into the nozzle 903 through the coolant inflow channel 901, and then the nozzle 903 sprays the coolant onto the surface of the chip 100 located in the cavity 902. After heat dissipation is performed on the chip 100, the coolant flows into the coolant outflow channel 904, and then flows out of the spraying module 900 through the coolant outflow channel 904. Due to arrangement of the second sealing member 910 and the third sealing member 920, cross-flow of the coolant can be avoided. For example, this can prevent the coolant from flowing out of the coolant inflow channel 901 and causing internal contamination of an electronic device.

In addition, the coolant sprayed by the spraying module enters the cavity, causing a pressure change in the cavity. The coolant inflow channel 901 deforms under squeezing and impact of the coolant, to release stress. This prevents the squeezing and impact of the coolant on the cavity from being transferred to the connection structure between the housing 600 and the printed circuit board 300, reduces stress on the interface between the housing 600 and the printed circuit board 300, and further improves connection strength between the housing 600 and the printed circuit board 300.

In addition, in some embodiments of this application, as shown in FIG. 10, a fourth sealing member 605 may be further disposed between the housing 600 and the printed circuit board 300.

The fourth sealing member 605 is disposed between the housing 600 and the printed circuit board 300 along an axial direction, and may be configured to seal a gap between the housing 600 and the printed circuit board 300, so as to prevent coolant sprayed by the spraying module 900 from leaking between the housing 600 and the printed circuit board 300.

The disposing along the axial direction means disposing along a direction parallel to an axis of the chip package structure. When disposed along the axial direction, the first sealing member 700 is fastened between the housing 600 and the printed circuit board 300 under pressure of the supporting member 800 and the housing 600 along the axial direction, to seal the gap between the housing 600 and the printed circuit board 300.

A mounting manner of the first sealing member 700 is not limited in this embodiment of this application. In an embodiment of this application, a fourth groove 6031 is provided on a surface that is of the first connection portion 603 (or the first support 602) of the housing 600 and that faces the printed circuit board 300. The fourth sealing member 605 is partially disposed in the fourth groove 6031 of the first support 602, and a surface of the fourth sealing member 605 is in contact with the printed circuit board 300.

In another embodiment, a fourth groove 6031 is provided on a surface that is of the printed circuit board 300 and that faces the first connection portion 603 (or the first support 602). The fourth sealing member 605 is partially disposed in the fourth groove 6031 of the first support 602, and a surface of the fourth sealing member 605 is in contact with a surface of the first connection portion 603 (or the first support 602).

In other embodiments, fourth grooves 6031 are provided on opposite surfaces of the printed circuit board 300 and the first connection portion 603 (or the first support 602). One part of the fourth sealing member 605 is disposed in a fourth groove 6031 of the printed circuit board 300, and the other part of the fourth sealing member 605 is disposed in a fourth groove 6031 of the first connection portion 603 (or the first support 602).

The fourth sealing member 605 may be squeezed during mounting, so that the fourth sealing member 605 elastically deforms when mounted in the fourth groove 6031, and a gap between the printed circuit board and the housing 600 can be better sealed.

In this way, according to the chip package structure provided in this embodiment of this application, the fourth sealing member 605 is disposed between the printed circuit board 300 and the housing 600 along the axial direction, so that stability of the chip package structure can be further improved.

FIG. 11 is a diagram of a structure of another chip package structure according to an embodiment of this application. In comparison with FIG. 8 and FIG. 11, it can be learned that a difference between the chip package structure shown in FIG. 11 and the chip package structure in FIG. 8 lies in that a housing 600 is disposed on a substrate 200, so that a chip 100 is located in a cavity 902 enclosed by the housing 600 and the substrate 200, and the cavity 902 is in communication with the outside only through a coolant inflow channel 901 and a coolant outflow channel 904. Therefore, the supporting member 800 and the first sealing member 700 shown in FIG. 8 do not need to be disposed in the cavity 902, and the structure is simpler.

A structure and a material of the housing 600 are not limited in this embodiment of this application. In an implementation of this application, the housing 600 includes an upper cover.

The upper cover and the substrate 200 are interlocked together, and the chip 100 is located in a region enclosed by the upper cover and the substrate 200.

In some embodiments of this application, the upper cover includes, for example, a top plate 601 and a first support 602. The first support 602 is supported on a printed circuit board 300, and the first support 602 is disposed around the chip 100.

Molding manners of the first support 602 and the top plate 601 are not limited in this embodiment of this application. In an implementation of this application, the first support 602 may be made of a same material as the top plate 601. During processing, the first support 602 and the top plate 601 may be integrally die-casted, and one end that is of the first support 602 and that is away from the top plate 601 may be fastened to the printed circuit board 300 through an adhesive.

In another implementation of this application, the first support 602 and the top plate 601 may be separately die-casted. For example, the first support 602 includes a first end and a second end that are opposite to each other. The first end of the first support 602 may be fastened to the top plate 601 through an adhesive, and the second end of the first support 602 may be fastened to the printed circuit board 300 through an adhesive.

A specific structure of the first support 602 is not limited in this embodiment of this application. In an implementation of this application, the first support 602 may be of a ring structure, and the first support 602 is, for example, evenly supported at an edge of the substrate 200.

In this way, the first support 602 may support the top plate 601 on the substrate 200, and evenly disperse gravity of the top plate 601 on the substrate 200.

A connection manner between the upper cover and the substrate 200 is not limited in this embodiment of this application. In some embodiments of this application, the upper cover is fastened to the substrate 200 by using a bolt.

In some other embodiments, the housing 600 is connected to the substrate 200 by using an adhesive.

In addition, as shown in FIG. 11, the chip package structure further includes an external connector. The external connector may be classified into an input external connector 9011 and an output external connector 9041. The input external connector 9011 is located in the coolant inflow channel 901, and the output external connector 9041 is located in the coolant outflow channel 904. The input external connector 9011 is configured to input coolant into a spraying module 900, and the output external connector 9041 is configured to export coolant in the cavity 902.

Quantities and positions of input external connectors 9011 and output external connectors 9041 are not limited in this embodiment of this application. In some embodiments, as shown in FIG. 11, there is one input external connector 9011 and two output external connectors 9041. A quantity of input external connectors 9011 is, for example, the same as a quantity of chips 100. That is, one input external connector 9011 corresponds to one chip 100.

Still refer to FIG. 11. A position of the input external connector 9011 is, for example, opposite to a position of the chip 100. The chip 100 is disposed, for example, in a middle position of the substrate 200, the input external connector 9011 is, for example, opposite to a center of the chip 100, and the two output external connectors 9041 are disposed on two sides of the input external connector 9011, so that coolant may enter the spraying module 900 through the middle input external connector 9011 to cool the chip 100 and flow out through the output external connector 9041.

In addition, a nozzle 903 facing the chip 100 is disposed on a surface of the cavity. The coolant flows to the nozzle 903 through the input external connector 9011, and then the nozzle 903 sprays the coolant onto the surface of the chip 100 located in the cavity 902. After heat dissipation is performed on the chip 100, the coolant flows into the output external connector 9041, and then flows out of the spraying module 900 through the output external connector 9041.

In this way, the input external connector 9011 is disposed opposite to the chip 100, so that the coolant input by the input external connector 9011 can be directly sprayed onto the surface of the chip 100, thereby better cooling the chip 100.

In some embodiments of this application, to further improve sealing performance of the cavity, a second sealing member 910 may be further disposed between the output external connector 9041 and the coolant outflow channel 904.

In some other embodiments of this application, a third sealing member 920 may be further disposed between the input external connector 9011 and the coolant inflow channel 901.

Both the second sealing member 910 and the third sealing member 920 are, for example, O-rings (O-Rings). Cross-sectional shapes of the second sealing member 910 and the third sealing member 920 are, for example, circles, and materials of the second sealing member 910 and the third sealing member 920 include an elastic material such as rubber. The second sealing member 910 and the third sealing member 920 may deform under squeezing and impact of the coolant, to release stress.

Mounting manners of the second sealing member 910 and the third sealing member 920 are not limited in this embodiment of this application. In some embodiments, the second sealing member 910 may be sleeved on an outer side wall of the output external connector 9041, so that the second sealing member 910 is in contact with an inner side wall of the coolant outflow channel 904.

In addition, the third sealing member 920 may be sleeved on an outer side wall of the input external connector 9011, to allow the third sealing member 920 be in contact with the coolant inflow channel 901.

In some other embodiments, refer to FIG. 11. A second groove 91 may be further provided on the inner side wall of the coolant outflow channel 904. The second sealing member 910 is partially disposed in the second groove 91, and a surface of the second sealing member 910 is in contact with the output external connector 9041.

In addition, a third groove 92 may be further provided on an inner side wall of the coolant inflow channel 901. The third sealing member 920 is partially disposed in the third groove 92, and a surface of the third sealing member 920 is in contact with the input external connector 9011.

During operation, the input external connector 9011 inputs coolant into the spraying module, so that the coolant flows into the nozzle 903 through the coolant inflow channel 901, and then the nozzle 903 sprays the coolant onto the surface of the chip 100 located in the cavity 902. After heat dissipation is performed on the chip 100, the coolant flows into the coolant outflow channel 904, and then flows out of the spraying module 900 through the coolant outflow channel 904. Due to arrangement of the second sealing member 910 and the third sealing member 920, cross-flow of the coolant can be avoided. For example, this can prevent the coolant from flowing out of the coolant inflow channel 901 and causing internal contamination of an electronic device.

In addition, the coolant sprayed by the spraying module enters the cavity, causing a pressure change in the cavity. The coolant inflow channel 901 deforms under squeezing and impact of the coolant, to release stress. This prevents the squeezing and impact of the coolant on the cavity from being transferred to a connection structure between the housing 600 and the printed circuit board 300, reduces stress on an interface between the housing 600 and the printed circuit board 300, and further improves connection strength between the housing 600 and the printed circuit board 300.

According to the chip package structure provided in this embodiment of this application, heat may be dissipated for the chip through the coolant in a liquid cooling manner, thereby improving heat dissipation performance of the chip. In addition, the sealing member is disposed between the outer side wall of the external connector and the inner side wall of the coolant transmission channel along a radial direction, so that coolant leakage can be avoided, and sealing performance of the chip package structure is improved. Further, the sealing member is used for radial sealing, so that sealing reliability can be implemented without of a connection member for fastening.

In addition, as shown in FIG. 12, the chip package structure further includes an external connector support 905. The external connector support 905 is configured to support the input external connector 9011 and the output external connector 9041.

A supporting member 800 may be further disposed on the printed circuit board 300. The supporting member 800 is disposed around the substrate 200, and is configured to support the external connector support 905.

In this way, in the chip package structure shown in FIG. 12, the supporting member 800 is disposed on the printed circuit board, and may be configured to support the external connector support 805. In addition, the supporting member 800 is disposed around an outer side of the substrate 200, so that the substrate 200 and the chip 100 can be better protected.

In some implementations, as shown in FIG. 12, the supporting member 800 includes a supporting member 801, a second connection portion 802, and a third connection portion 803. The supporting member 801 includes a first end and a second end that are opposite to each other. The first end of the supporting member 801 is connected to the first connection portion 801, and the second end of the supporting member 801 is connected to the third connection portion 803.

The second connection portion 802 extends from the supporting member 801 toward the spraying module 900. The external connector support 905 is in lap joint with the second connection portion 802, and the external connector support 905 is connected to the second connection portion 802.

A connection manner between the external connector support 905 and the second connection portion 802 is not limited in this embodiment of this application. In some embodiments, the external connector support 905 is connected to the second connection portion 802 by using an adhesive. In some other embodiments, the external connector support 905 is connected to the second connection portion 802 by using a second connection member 63. The second connection member 63 may be a bolt, a screw, or the like.

The third connection portion 803 extends from the supporting member 801 to a direction away from the substrate 200. The third connection portion 803 is disposed on the printed circuit board 300, and is connected to the printed circuit board 300.

A connection manner between the printed circuit board 300 and the third connection portion 803 is not limited in this embodiment of this application. In some embodiments, the printed circuit board 300 is connected to the third connection portion 803 by using an adhesive. In some other embodiments, the printed circuit board 300 is connected to the third connection portion 803 by using a third connection member 64. The third connection member 64 may be a bolt, a screw, or the like.

According to the chip package structure provided in this embodiment of this application, the supporting member is disposed outside a cavity enclosed by the substrate and the housing, and the supporting member is connected to the printed circuit board by using a first connection member. This improves connection stability, and clamping force cannot be transferred to the substrate, thereby avoiding squeezing on an electrical connector between the substrate and the printed circuit board. This prevents the spraying module from striking the chip under kinetic energy during falling or impact, thereby avoiding a surface defect on the chip or crushing of the electrical connector.

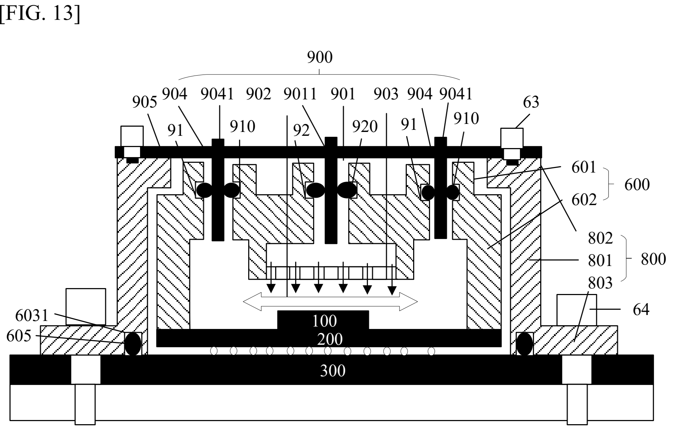

In addition, in some embodiments of this application, as shown in FIG. 13, a fourth sealing member 605 may be further disposed between the supporting member 800 and the printed circuit board 300.

The fourth sealing member 605 is disposed between the supporting member 800 and the printed circuit board 300 along an axial direction, and may be configured to seal a gap between the supporting member 800 and the printed circuit board 300, so as to further prevent the coolant sprayed by the spraying module 900 from leaking between the supporting member 800 and the printed circuit board 300.

A mounting manner of the fourth sealing member 605 is not limited in this embodiment of this application. In an embodiment of this application, a fourth groove 6031 is provided on a surface that is of the third connection portion 803 (or the supporting member 801) of the supporting member 800 and that faces the printed circuit board 300. The fourth sealing member 605 is partially disposed in the fourth groove 6031 of a first support 602, and a surface of the fourth sealing member 605 is in contact with the printed circuit board 300.

In another embodiment, a fourth groove 6031 is provided on a surface that is of the printed circuit board 300 and that faces the third connection portion 803 (or the supporting member 801). The fourth sealing member 605 is partially disposed in the fourth groove 6031 of a first support 602, and a surface of the fourth sealing member 605 is in contact with a surface of the third connection portion 803 (or the supporting member 801).

In other embodiments, fourth grooves 6031 are disposed on opposite surfaces of the printed circuit board 300 and the third connection portion 803 (or the supporting member 801). One part of the fourth sealing member 605 is disposed in a fourth groove 6031 of the printed circuit board 300, and the other part of the fourth sealing member 605 is disposed in a fourth groove 6031 of the third connection portion 803 (or the supporting member 801).

The fourth sealing member 605 may be squeezed during mounting, so that the fourth sealing member 605 elastically deforms when mounted in the fourth groove 6031, and a gap between the printed circuit board and the supporting member 800 can be better sealed.

In this way, according to the chip package structure provided in this embodiment of this application, the fourth sealing member 605 is disposed between the printed circuit board 300 and the supporting member 800 along the axial direction, so that stability of the chip package structure can be further improved.

The foregoing descriptions are merely specific implementations of this application. However, the protection scope of this application is not limited thereto. Any change or replacement within the technical scope disclosed in this application shall fall within the protection scope of this application. Therefore, the protection scope of this application shall be subject to the protection scope of the claims.

## Claims

1. A chip package structure, comprising a substrate;
a housing, wherein the housing comprises a first support and a top plate, the first support is disposed around the substrate, and the top plate is disposed on the first support;
a chip and a supporting member, disposed on a first surface of the substrate, wherein both the chip and the supporting member are located in a region enclosed by the housing, and the supporting member is disposed around the chip; a spraying module, wherein the spraying module is disposed on the housing, and the spraying module faces the chip; and
a first sealing member, wherein the first sealing member is disposed between the supporting member and the housing along a radial direction.

2. The chip package structure according to claim 1, wherein the first sealing member is located between an outer side wall of the supporting member and an inner side wall of the first support.

3. The chip package structure according to claim 2, wherein a first groove is provided on a surface that is of the supporting member and that faces the first support, and the first sealing member is partially disposed in the first groove.

4. The chip package structure according to claim 2 or 3, wherein a second groove is provided on a surface that is of the first support and that faces the supporting member, and the first sealing member is partially disposed in the second groove.

5. The chip package structure according to claim 1, wherein the housing further comprises a second support, the second support is located on an inner side of the first support, the second support is connected to the top plate, the second support is disposed around the spraying module, and the first sealing member is disposed between an outer side wall of the second support and an inner side wall of the supporting member.

6. The chip package structure according to any one of claims 1 to 5, further comprising: a printed circuit board, wherein both the substrate and the housing are disposed on the printed circuit board, the housing and the printed circuit board enclose a cavity, and the substrate is located in the cavity.

7. The chip package structure according to claim 6, wherein the housing further comprises a connection portion, the connection portion is disposed on the printed circuit board, and the connection portion is connected to the printed circuit board by using a connection member.

8. The chip package structure according to claim 7, wherein a second sealing member is disposed between the connection portion and the printed circuit board.

9. The chip package structure according to any one of claims 1 to 8, wherein the spraying module comprises a nozzle, the nozzle is in communication with the cavity, and a projection of the nozzle onto the printed circuit board is greater than or equal to a projection area of the chip onto the printed circuit board.

10. The chip package structure according to any one of claims 1 to 9, further comprising: a third sealing member, an external connector, and a coolant transmission channel, wherein the external connector is disposed in the coolant transmission channel, and the third sealing member is disposed between an outer side wall of the external connector and an inner side wall of the coolant transmission channel along the radial direction.

11. A chip package structure, comprising a substrate;
a chip and a housing, both disposed on a first surface of the substrate, wherein the housing and the substrate enclose a cavity, and the chip is located in the cavity; a spraying module, wherein the spraying module is disposed on the housing, the spraying module faces the chip, and a coolant transmission channel is provided on the spraying module;
an external connector, wherein the external connector is disposed in the coolant transmission channel; and
a sealing member, wherein the sealing member is disposed between an outer side wall of the external connector and an inner side wall of the coolant transmission channel.

12. The chip package structure according to claim 11, wherein the external connector comprises an input external connector and an output external connector, the coolant transmission channel comprises a coolant inflow channel and a coolant outflow channel, the sealing member comprises a first sealing member and a second sealing member, the input external connector is disposed in the coolant inflow channel, the first sealing member is disposed between the input external connector and the coolant inflow channel, the output external connector is disposed in the coolant outflow channel, and the second sealing member is disposed between the output external connector and the coolant outflow channel.

13. The chip package structure according to claim 12, wherein a first groove is provided on a surface that is of the coolant inflow channel and that faces the input external connector, the first sealing member is partially disposed in the first groove, a surface of the first sealing member is in contact with an outer side wall of the input external connector, a second groove is provided on a surface that is of the coolant outflow channel and that faces the output external connector, the second sealing member is partially disposed in the second groove, and a surface of the second sealing member is in contact with an outer side wall of the output external connector.

14. The chip package structure according to any one of claims 11 to 13, further comprising: a printed circuit board and a supporting member, wherein the substrate and the supporting member are disposed on a first surface of the printed circuit board, and the supporting member is disposed around the substrate.

15. The chip package structure according to claim 14, wherein the supporting member comprises a support and a first connection portion, the first connection portion is located at one end of the support, the first connection portion is disposed close to the printed circuit board, and the first connection portion is connected to the printed circuit board by using a first connection member.

16. The chip package structure according to claim 15, wherein a third sealing member is disposed between the first connection portion and the printed circuit board.

17. The chip package structure according to claim 16, wherein a third groove is provided on a surface that is of the first connection portion and that faces the printed circuit board, the third sealing member is partially disposed in the third groove, and a surface of the third sealing member is in contact with the first surface of the printed circuit board.

18. The chip package structure according to claim 16 or 17, further comprising: an external connector support, wherein the external connector support is disposed on a top of the supporting member, the supporting member further comprises a second connection portion, the second connection portion is located at another end of the supporting member, and the external connector support is connected to the second connection portion by using the second connection member.

19. An electronic device, wherein the electronic device comprises the chip package structure according to any one of claims 1 to 18.

20. The electronic device according to claim 19, wherein the electronic device further comprises a server.
